# EUROPÄISCHE PATENTSCHRIFT

(11) **EP 3 931 580 B1**
(45) Veröffentlichungstag und Bekanntmachung des Hinweises auf die Patenterteilung: **12.10.2022**
(21) Anmeldenummer: 20725673.6
(22) Anmeldetag: 06.05.2020
(51) Int. Cl.: G01R 13/02, H03K 5/1534, H03M 9/00

(54) **VERFAHREN UND AUSWERTEEINHEIT ZUR ERMITTLUNG EINES ZEITPUNKTS EINER FLANKE IN EINEM SIGNAL**
METHOD AND EVALUATION UNIT FOR DETERMINING A TIME OF A FLANK IN A SIGNAL
PROCÉDÉ ET UNITÉ D'ÉVALUATION POUR DÉTERMINER UN INSTANT D'UN FRONT DANS UN SIGNAL

(30) Priorität: 13.05.2019 DE 102019112447
(43) Veröffentlichungstag der Anmeldung: 05.01.2022
(73) Patentinhaber: JENOPTIK Optical Systems GmbH, 07745 Jena (DE)
(72) Erfinder: BERNER, Dirk, 07751 Großpürschütz (DE)
(74) Vertreter: Waldauf, Alexander
(86) Internationale Anmeldenummer: PCT/EP2020/062591
(87) Internationale Veröffentlichungsnummer: WO 2020/229265

(56) Entgegenhaltungen:
- CN-A- 107 659 392
- US-A- 5 757 297
- US-A1- 2009 052 600
- US-A1- 2013 341 518
- US-A1- 2017 254 835
- US-B1- 8 098 787

## Beschreibung

Der hier vorgestellte Ansatz betrifft ein Verfahren und eine Auswerteeinheit zur Ermittlung eines Zeitpunkts einer Flanke in einem Signal. Insbesondere kann der hier vorgestellte Ansatz zu Messung von Laufzeiten, beispielsweise im Bereich der Laserpuls-Laufzeiterfassung für ein Verkehrsüberwachungssystem verwendet werden.

In konventionellen Systemen zur Laufzeitmessung wird oftmals eine Abtastung von Eingangssignalen mit einem vorhandenen (langsamen) Systemtakt vorgenommen. Denkbar ist ferner die Verwendung eines separaten Zeitmessschaltkreises für die Zeitmessung. Der Zeitmessschaltkreis kann beispielsweise als ein zusätzlicher Schaltkreis (IC) implementiert sein, der die Zeitpunkte der Pegelwechsel von Eingangssignalen sehr genau bestimmen kann.

Die Abtastung mittels Systemtakt führt zu einer geringen Zeitauflösung. Es ist eine signifikante Erhöhung des Systemtaktes denkbar, die aber in programmierbaren digitalen Schaltungen erhebliche Nachteile, wie z. B. deutlich längere Place&Route-Zeiten, Verwendung von ICs mit höherer Leistungsaufnahme und höheren Stromverbrauch nach sich zieht oder gegebenenfalls nicht realisierbar ist.

Der Nachteil der Zeitmessschaltkreise ist ihre geringe Kanalanzahl, sie verursachen zusätzliche Kosten und benötigen zusätzlichen Strom und Platz in der Schaltung. Ein Zeitmessschaltkreis kann in einer definierten Zeit nur wenige Flanken auswerten und sollte ferner regelmäßig kalibriert werden. In programmierbaren Schaltkreisen gibt es Implementierungen der Zeitmessung unter Verwendung von internen Laufzeitgliedern. Die Implementierung über interne Laufzeitglieder benötigt viele Ressourcen für viele Eingangssignale. Die Realisierung führt zu stark unterschiedlichen Ergebnissen bei der Implementierung und zu erheblichen differentiellen und integralen Nichtlinearitäten. Die Implementierung ist nur mit erheblichem Aufwand in andere digitale Schaltungen zu portieren. Es ist eine Designbeschreibung auf unterster Technologieebene mit einer Vielzahl von Synthese- und Implementierungsvorgaben, sogenannten Constraints notwendig. Die beschriebenen Verfahren sind sehr komplex und wartungsintensiv.

Die US 8 098 787 B1 und die US 2013/0341518 A1 offenbaren ein Verfahren zur Ermittlung eines Zeitpunkts einer Flanke in einem Signal. Das Verfahren weist dabei einen Schritt des Einlesens des Signals und eines Grundtaktes zum Betrieb einer digitalen Auswerteeinheit zur Auswertung des Zeitpunktes der Flanke auf. Ferner weist das Verfahren einen Schritt des Bildens eines das Signal repräsentierenden Datenworts unter Verwendung eines Deserialisierers einer SERDES-Zelle auf, wobei das Datenwort eine Mehrzahl von Bits aufweist und wobei die SERDES-Zelle ferner mit einem Abtasttakt zur Abtastung des Signals beaufschlagt wird, der höher als der Grundtakt ist, wobei zur Abtastung des Signals eine Flanke oder zwei Flanken des Abtasttaktes verwendet werden. Abschließend wird der Zeitpunkt der Flanke in dem Signal unter Verwendung des Datenworts und des Grundtaktes in der digitalen Auswerteeinheit ermittelt.

Vor diesem Hintergrund wird mit dem vorgestellten Ansatz eine Möglichkeit zur Verbesserung der Ermittlung eines Zeitpunktes einer Flanke in einem Signal geschaffen.

Es wird daher ein Verfahren gemäss dem Anspruch 1 zur Messung eines Zeitpunkts einer Flanke in einem Signal vorgestellt.

Unter einem Zeitpunkt einer Flanke in einem Signal kann beispielsweise ein Zeitpunkt eines Pegelwechsels oder eines Signalsprungs in dem Signal verstanden werden. Eine solche Flanke kann beispielsweise das Eintreffen eines erwarteten Signals darstellen, sodass der Zeitpunkt dieser Flanke zu einer Auswertung einer Laufzeit eines Signals verwendet werden kann. Unter einem Deserialisierer kann beispielsweise eine Komponente verstanden werden, mittels welcher Signale auf einer einzelnen Signalleitung zeitlich abgetastet werden und die erhaltenen Abtastwerte jeweils in einem Block in einem parallel auszugebenden Datenwort abgespeichert oder abgelegt werden. Unter einer SERDES-Zelle kann eine Komponente verstanden werden, welche zur Übertragung von Datenworten auf einer einzelnen Datenleitung ausgelegt ist, wobei die einzelnen Komponenten der Datenworte parallel eingelesen, parallel-seriell-gewandelt und seriell über die Datenleitung übertragen werden und anschließend wieder seriellparallel-gewandelt werden, um als empfangene Datenworte zur Verfügung gestellt zu werden. Eine solche SERDES-Zelle arbeitet hierbei mit einem Abtasttakt, der größer als ein für den Betrieb einer elektronischen Schaltung verwendeter Systemtakt/Grundtakt ist, um diese abgetasteten Werte des Signals in den Bits des bereitzustellenden Datenwortes ablegen zu können und hieraus die seriell über die Datenleitung zu übertragenden Werte zu ermitteln. Der Schritt des Ermittelns kann beispielsweise ferner unter Verwendung des Abtasttaktes ausgeführt werden.

Der hier vorgestellte Ansatz basiert auf der Erkenntnis, dass oftmals bereits verfügbare SERDES-Zellen bzw. Komponenten dieser Zellen verwendet werden können, um gerade die Zeitpunkte von Flanken in Signalen sehr präzise ermitteln zu können. Hierbei wird ausgenutzt, dass bei derartigen SERDES-Zellen eine hohe Abtastrate verwendet wird, die üblicherweise höher als der Systemtakt bzw. Grundtakt ist, der zum Betrieb der elektronischen Schaltung bzw. der Auswerteeinheit verwendet wird, sodass eine zeitliche Auflösung des Eintreffzeitpunktes der Flanke des Signals möglich wird, der die maximale zeitliche Auflösung bei der Verwendung des Grundtaktes deutlich überschreitet. Konkret wird hierbei das auf der Daten- bzw. Signalleitung geführte Signal dem Eingang des Deserialisierers zugeführt, der nun aus diesem Signal ein entsprechendes n-Bit-Datenwort erzeugt. Das Signal kann hierbei als digitales Signal vorliegen. Bei einem Pegelwechsel oder Signalsprung als Flanke in diesem Signal, bei dem beispielsweise durch das Eintreffen der Flanke der Zustand des Signals von einem Wert von logisch 0 ("Low") auf einen Wert von logisch 1 ("High") wechselt, kann der Zeitpunkt dieses Wechsels, Sprungs bzw. der Flanke in dem Signal bei der Kenntnis des Abtasttaktes sowie des Datenwortes dadurch ermittelt werden, dass festgestellt wird, an welcher Stelle in dem Datenwort der Wechsel bzw. Sprung des Zustands oder Signalpegels erkannt wurde, wobei jede Position bzw. Stelle in diesem Datenwort einer Periode bzw. einem Zyklus des Abtasttaktes entspricht. Denkbar ist ferner auch, dass zwei Flanken, hier als beide Flanken, d. h., die Anfangs- und Endflanke, des Abtasttaktes verwendet werden. Durch die Bestimmung der Perioden bzw. eines Zyklus des Grundtaktes sowie bei dem Auftreten einer Flanke, eines Sprungs bzw. Pegelwechsels in dem Signal auch durch die Bestimmung der Periode bzw. des Zyklus des Abtasttaktes kann somit eine sehr präzise Messung des Zeitpunktes des Auftretens der Flanke in dem Signal erfolgen. Zugleich lässt sich eine solche Möglichkeit durch die Verwendung einer Komponente der bekannten SERDES-Zelle technisch sehr einfach implementieren, insbesondere beispielsweise auch in digitale Schaltungen wie FPGAs oder ASICs.

Erfindungsgemäß wird im Schritt des Bildens eines das Signal repräsentierenden zweiten Datenwortes dieses zweite Datenwort unter Verwendung eines Deserialisieres einer zweiten SERDES-Zelle gebildet, wobei das zweite Datenwort eine Mehrzahl von Bits aufweist, insbesondere wobei zur Abtastung des Signals beide Flanken des Abtasttaktes verwendet werden, wobei die zweite SERDES-Zelle mit einem zum Abtasttakt um einen vorbestimmten Phasenwinkel verschobenen zweiten Abtasttakt zur Abtastung des Signals beaufschlagt wird, insbesondere wobei der zweite Abtasttakt zum Abtasttakt um einen Phasenwinkel von 90 Grad verschoben ist, und wobei im Schritt des Ermittelns der Zeitpunkt ferner unter Verwendung des zweiten Datenworts ermittelt wird. Beispielsweise kann hierbei das gleiche Signal parallel dem Deserialisierer der SERDES-Zelle und dem Deserialisierer der zweiten SERDES-Zelle zugeführt werden. Eine solche Ausführungsform bietet den Vorteil, eine nochmals erhöhte Präzision der Bestimmung des Zeitpunktes des Eintreffens der Flanke im Signal zu ermöglichen, da durch die Verwendung des Abtasttaktes in der (ersten) SERDES-Zelle und der Verwendung des zweiten, phasenverschobenen Abtasttaktes in der zweiten SERDES-Zelle ein Zeitpunkt eines Auftretens der Flanke in dem Signal ermittelt werden kann, der innerhalb einer Periodendauer des Abtasttaktes liegt, da ein solcher Auftrittszeitpunkt der Flanke sehr präzise durch den Deserialisierer der zweiten SERDES-Zelle erfasst werden kann. Erfindungsgemäß werden im Schritt des Ermittelns die Werte des Datenwortes und des zweiten Datenwortes abwechselnd zu Werten eines Gesamtwortes zusammengefügt, wobei der Zeitpunkt ferner unter Verwendung des Gesamtwortes ermittelt wird. Eine solche Ausführungsform des hier vorgestellten Ansatzes bietet den Vorteil, durch die mit den phasenverschobenen Abtasttakten abgetasteten Werte des Signals an den unterschiedlichen Positionen des Gesamtwortes den ermittelten bzw. gemessenen Zeitpunkt der Flanke mit einer sehr hohen Genauigkeit in dem Signal bestimmen zu können.

Günstig ist ferner eine Ausführungsform des hier vorgeschlagenen Ansatzes, bei der im Schritt des Bildens ein Synchronisieren des Abtasttaktes mit dem Grundtakt erfolgt, bevor die SERDES-Zelle mit dem Abtasttakt beaufschlagt wird, insbesondere wobei der Abtasttakt und der Grundtakt von einem von einem Taktgenerator bereitgestellten Signal abgeleitet wurden. Eine solche Ausführungsform des hier vorgeschlagenen Ansatzes bietet den Vorteil einer besonders einfachen Ermittlung des Zeitpunktes, da der Beginn von Zyklen des Abtasttaktes mit dem Beginn von Zyklen des Grundtaktes zusammenfallen, sodass der Zeitpunkt des Eintreffens der Flanke im Signal durch eine einfache Addition von Periodendauer des Grundtaktes sowie abhängig von Informationen in den Datenwort einer oder mehreren Periodendauern des Abtasttaktes ermittelt werden kann.

Gemäß einer weiteren Ausführungsform des hier vorgeschlagenen Ansatzes kann im Schritt des Bildens ferner ein das Signal repräsentierendes weiteres Datenworts unter Verwendung eines Deserialisierers einer weiteren SERDES-Zelle gebildet werden, wobei das weitere Datenwort eine Mehrzahl von Bits aufweist und wobei die weitere SERDES-Zelle ferner mit einem weiteren Abtasttakt zur Abtastung des Signals beaufschlagt wird, der höher als der Grundtakt ist und wobei die SERDES-Zelle und die weitere SERDES-Zelle auf je unterschiedliche Vorzeichen eines Pegelwechsels im Signal sensitiv sind. Hierbei kann im Schritt des Ermittelns der Zeitpunkt der Flanke in dem Signal unter Verwendung des weiteren Datenworts und des Grundtaktes in der Auswerteeinheit ermittelt werden, um den Zeitpunkt der Flanke in dem Signal zu messen. Als weiterer Abtasttakt kann beispielsweise der Abtasttakt verwendet werden. Beispielsweise kann die SERDES-Zelle auf steigende Flanken oder Pegelwechsel im Signal sensitiv sein, während die weitere SERDES-Zelle auf fallende Flanken oder Pegelwechsel im Signal sensitiv ist. Das Signal kann beispielsweise parallel der SERDES-Zelle und der weiteren SERDES-Zelle zugeführt werden. Eine solche Ausführungsform des hier vorgeschlagenen Ansatzes bietet den Vorteil einer weiteren Erhöhung der Präzision der Bestimmung eines Zeitpunktes einer Flanke in einem Signal, da nunmehr mehrere mögliche auftretende Pegelwechsel im Signal erfasst werden können.

Denkbar ist ferner eine Ausführungsform des hier vorgeschlagenen Ansatzes, bei der im Schritt des Bildens die weitere SERDES-Zelle ausgebildet ist, um ein weiteres Datenwort auszugeben, das eine von der Bitzahl des Datenworts der ersten SERDES-Zelle abweichende Bitzahl aufweist. Eine solche Ausführungsform des hier vorgeschlagenen Ansatzes bietet eine Flexibilität in Bezug auf die Präzision der Bestimmung von Zeitpunkten der Flanken in einem Signal, wobei je nach Erfordernis der Auswertung beispielsweise steigende Flanken oder Pegelwechsel im Signal mit anderer Präzision erfasst werden können als fallende Flanken oder Pegelwechsel.

Auch kann gemäß einer weiteren Ausführungsform im Schritt des Bildens ein das Signal repräsentierendes zusätzliches Datenwort unter Verwendung einer zusätzlichen SERDES-Zelle gebildet werden, das eine Mehrzahl von Bits aufweist, wobei die zusätzliche SERDES-Zelle mit einem zum Abtasttakt um einen vorbestimmten Phasenwinkel verschobenen zusätzlichen Abtasttakt zur Abtastung des Signals beaufschlagt wird, insbesondere wobei der zusätzliche Abtasttakt zum Abtasttakt um einen Phasenwinkel von 90 Grad verschoben ist, und wobei im Schritt des Ermittelns der Zeitpunkt ferner unter Verwendung des zusätzlichen Datenworts ermittelt wird. Beispielsweise kann als der zusätzliche Abtasttakt der zweite Abtasttakt verwendet werden. Das Signal kann beispielsweise parallel der weiteren SERDES-Zelle und der zusätzlichen SERDES-Zelle zugeführt werden. Auch durch eine solche Ausführungsform lässt sich mit einer sehr hohen Präzision der Zeitpunkt des Eintreffens einer Flanke oder eines Pegelwechsels ermitteln, insbesondere bei der Ermittlung des Zeitpunktes einer fallenden Flanke.

Besonders vorteilhaft ist eine Ausführungsform des hier vorgeschlagenen Ansatzes, bei der das Signal im Schritt des Einlesens vor dem Zuführen zu mindestens einer der SERDES-Zellen verzögert wird, insbesondere einstellbar verzögert wird. Eine solche Ausführungsform bietet den Vorteil, das Signal in Abhängigkeit von einer verwendeten Technologie für die SERDES-Zelle und/oder von Umwelteinflüssen verzögern zu können, sodass eine möglichst hohe Präzision der Bestimmung des Zeitpunktes der Flanke oder des Pegelwechsels in dem Signal ermöglicht wird.

In einer besonders vorteilhaften Ausführungsform kann ein Verfahren zur Bestimmung einer Laufzeit und/oder einer Pulsbreite eines Testsignals implementiert werden, wobei ein Zeitpunkt und/oder Zeitpunkte einer steigenden und/oder einer fallenden Flanke eines auszusendenden Testsignals und/oder ein Zeitpunkt und/oder Zeitpunkte einer steigenden und/oder einer fallenden Flanke eines empfangenen Testsignals unter Verwendung der Schritte einer Varianten eines hier vorgestellten Verfahrens zur Ermittlung eines Zeitpunktes einer Flanke in einem Signal gemessen wird, wobei ferner in einem Schritt des Bestimmens die Laufzeit unter Verwendung des Zeitpunkts der steigenden und/oder fallenden Flanke bestimmt wird. Eine solche Ausführungsform bietet den Vorteil einer sehr präzisen Bestimmung der Laufzeit eines Signals, insbesondere wenn eine Auswertung der Laufzeit als Basis einer Messung in Bußgeldverfahren oder Strafverfahren oder als Zeitmessung elektromagnetischer Signale in verschiedenen Medien wie Luft oder Flüssigkeiten verwendet werden soll.

Besonderes Augenmerk kann hierbei auf eine Ausführungsform des hier vorgestellten Ansatzes gerichtet werden, bei dem die Laufzeit eines Laserimpulses eines Verkehrsüberwachungsgerätes als Testsignal bestimmt wird. Eine solche Ausführungsform bietet den Vorteil, gerade sehr kurze Laufzeiten eines mit Lichtgeschwindigkeit laufenden Laserpulses unter Verwendung des hier vorgeschlagenen Ansatzes hinreichend präzise erkennen zu können, um hierauf aufbauend eine juristisch haltbare Messung im Bereich der Verkehrsüberwachung zu erreichen.

Der hier vorgestellte Ansatz schafft ferner eine Auswerteeinheit, die ausgebildet ist, um die Schritte eines hier vorgestellten Verfahrens in entsprechenden Einrichtungen durchzuführen, anzusteuern bzw. umzusetzen. Auch durch diese Ausführungsvariante der Erfindung in Form einer Auswerteeinheit kann die der Erfindung zugrundeliegende Aufgabe schnell und effizient gelöst werden.

Hierzu kann die Auswerteeinheit zumindest eine Recheneinheit zum Verarbeiten von Signalen oder Daten, zumindest eine Speichereinheit zum Speichern von Signalen oder Daten, zumindest eine Schnittstelle zu einem Sensor oder einem Aktor zum Einlesen von Sensorsignalen von dem Sensor oder zum Ausgeben von Daten- oder Steuersignalen an zumindest eine Kommunikationsschnittstelle zum Einlesen oder Ausgeben von Daten aufweisen, die in ein Kommunikationsprotokoll eingebettet sind. Die Recheneinheit kann beispielsweise ein Signalprozessor, ein Mikrocontroller oder dergleichen sein, wobei die Speichereinheit ein Flash-Speicher, ein EEPROM oder eine magnetische Speichereinheit sein kann. Die Kommunikationsschnittstelle kann ausgebildet sein, um Daten drahtlos und/oder leitungsgebunden einzulesen oder auszugeben, wobei eine Kommunikationsschnittstelle, die leitungsgebundene Daten einlesen oder ausgeben kann, diese Daten beispielsweise elektrisch oder optisch aus einer entsprechenden Datenübertragungsleitung einlesen oder in eine entsprechende Datenübertragungsleitung ausgeben kann.

Unter einer Auswerteeinheit kann vorliegend ein elektrisches Gerät verstanden werden, das Sensorsignale verarbeitet und in Abhängigkeit davon Steuer- und/oder Datensignale ausgibt. Die Auswerteeinheit kann eine Schnittstelle aufweisen, die hard- und/oder softwaremäßig ausgebildet sein kann. Bei einer hardwaremäßigen Ausbildung können die Schnittstellen beispielsweise Teil eines sogenannten FPGAs oder System-ASICs sein, der verschiedenste Funktionen der Auswerteeinheit beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

Gemäß einer vorteilhaften Ausführungsform des hier vorgestellten Ansatzes kann die Auswerteeinheit als digitaler integrierter Schaltkreis, insbesondere als konfigurierbarer digitaler integrierter Schaltkreis ausgebildet sein. Eine solche Ausführungsform bietet den Vorteil, breit verfügbare Komponenten für die Umsetzung des hier vorgeschlagenen Ansatzes verwenden und mit technisch einfachen Mitteln entsprechend konzentrieren zu können. Zugleich arbeitet eine solche Ausführungsform meist sehr schnell und ist somit gut als Hardware-Grundlage zur Ausführung des hier vorgestellten Ansatzes ersetzbar.

Denkbar ist ferner auch eine Ausführungsform des hier vorgestellten Ansatzes, bei der zumindest ein Takteingangsanschluss vorgesehen ist, um den Grundtakt und/oder den Abtasttakt der Auswerteeinheit von außerhalb der Auswerteeinheit zuzuführen. Eine solche Ausführungsform bietet den Vorteil, für die Verwendung eines oder mehrerer der unterschiedlichen Takte eine externe Taktquelle verwenden zu können, welche beispielsweise eine hohe Präzision in Bezug auf einen Jitter oder die Bereitstellung von hohen Taktfrequenzen aufweist, welche beispielsweise bei in entsprechenden Schaltkreisen integrierten Taktgeneratoren möglicherweise nicht ausreichend verfügbar ist.

Von Vorteil ist auch ein Computerprogrammprodukt oder Computerprogramm mit Programmcode, der auf einem maschinenlesbaren Träger oder Speichermedium wie einem Halbleiterspeicher, einem Festplattenspeicher oder einem optischen Speicher gespeichert sein kann und zur Durchführung, Umsetzung und/oder Ansteuerung der Schritte des Verfahrens nach einer der vorstehend beschriebenen Ausführungsformen verwendet wird, insbesondere wenn das Programmprodukt oder Programm auf einem Computer oder einer Auswerteeinheit ausgeführt wird.

Günstige Ausführungsbeispiele des hier vorgestellten Ansatzes werden nachfolgend anhand der beigefügten Figuren exemplarisch beschrieben. Es zeigen:
Fig. 1 eine schematische Darstellung eines Verkehrsüberwachungsgerätes bei der Messung einer Geschwindigkeit eines Fahrzeugs mit einer Auswerteeinheit gemäß einem Ausführungsbeispiel;
Fig. 2 ein Diagramm mit mehreren Signalverläufen, um die prinzipielle Funktionsweise des hier vorgestellten Ansatzes zu erläutern;
Fig. 3 ein Blockschaltbild eines prinzipiellen Aufbaus einer Auswerteeinheit gemäß einem Ausführungsbeispiel für eine Zeitmessung in einer sehr einfachen Form;
Fig. 4 ein Blockschaltbild einer Variante einer Auswerteeinheit gemäß einem Ausführungsbeispiel unter Verwendung von zwei SERDES-Zellen;
Fig. 5 ein Diagramm mit mehreren Signalverläufen, um die prinzipielle Funktionsweise der Auswerteeinheit gemäß Fig. 4 zu erläutern;
Fig. 6 ein Blockschaltbild eines prinzipiellen Aufbaus einer Auswerteeinheit gemäß einem Ausführungsbeispiel für eine Zeitmessung in einer erweiterten Form; und
Fig. 7 ein Ablaufdiagramm eines Ausführungsbeispiels des hier vorgestellten Ansatzes als Verfahren zur Messung eines Zeitpunkts einer Flanke in einem Signal.

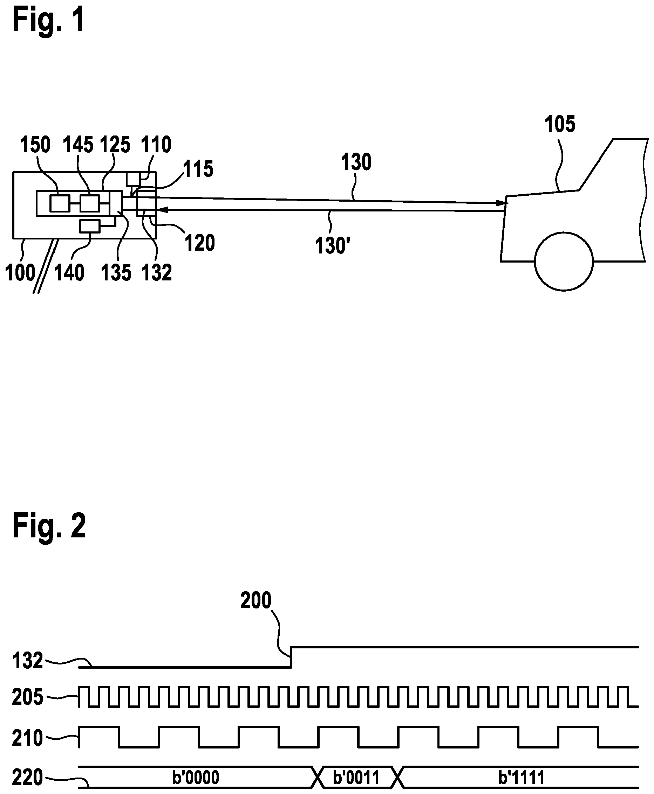

Fig. 1 zeigt eine schematische Darstellung eines Verkehrsüberwachungsgerätes 100 bei der Messung einer Geschwindigkeit eines Fahrzeugs 105. Das Verkehrsüberwachungsgerät 100 ist beispielsweise als Laserpistole ausgestaltet, die von einem Polizisten zur Überwachung von Verstößen gegen eine maximal zulässige Geschwindigkeit auf einem Straßenabschnitt verwendet werden kann. Um nun diese Übertretung einer maximal zulässigen Geschwindigkeit durch das Fahrzeug 105 zu ermitteln, kann eine Auslöseeinheit 110 in dem Verkehrsüberwachungsgerät 100 ein Startsignal 115 an eine Lasereinheit 120 und an eine Auswerteeinheit 125 ausgeben, um die Lasereinheit 120 zur Ausgabe eines Laserimpulses 130 anzusteuern und der Auswerteeinheit eine Information über das Aussenden des Laserimpulses 130 zu geben. Die Lasereinheit 120 umfasst beispielsweise eine in der Fig. 1 nicht dargestellte Laserdiode, die den Laserimpuls 130 generiert und in Richtung des Fahrzeugs 105 aussendet. Zugleich kann in der Auswerteeinheit 125 ein Zeitpunkt des Empfangs des Startsignals erkannt werden und eine Zeitmessung gestartet werden. An einer Oberfläche des Fahrzeugs 105 wird der Laserimpuls 130 reflektiert, in der Lasereinheit 130 im Verkehrsüberwachungsgerätes 100 als reflektierter Laserimpuls 130' wieder empfangen und unter Verwendung eines in der Fig. 1 nicht explizit dargestellten Lasersensors in ein Empfangssignal 132 gewandelt, welches nun ebenfalls der Auswerteeinheit 125 zugeführt wird. Aus dem Startsignal 115 und dem Empfangssignal 132 kann nun in der Auswerteeinheit 125 die Ermittlung einer Laufzeit des Laserimpulses 130 vom Aussenden durch die Lausereinheit 120 bis zum Empfang des reflektierten Laserimpulses 130' ermittelt werden, die bei Kenntnis der Lichtgeschwindigkeit zu einer Ermittlung des Abstandes zwischen dem Fahrzeug 105 und dem Verkehrsüberwachungsgerätes 100 genutzt werden kann. Für eine solche Laufzeitmessung wird der Zeitpunkt des Eintreffens des Signals 130' gemessen, wobei zunächst in einer Einleseschnittstelle 135 das den reflektierten Laserimpuls repräsentierende Empfangssignal 132 (das in den nachfolgenden Ausführungen der Einfachheit halber lediglich als Signal bezeichnet wird) sowie von einem Taktgenerator 140 ein Grundtakt zum Betrieb der digitalen Auswerteeinheit zur Auswertung des Zeitpunktes der Flanke eingelesen wird. Die eingelesenen Informationen aus dem Signal 132 werden dann einer Bildungseinheit 145 zum Bilden eines das Signal 132 repräsentierenden Datenworts unter Verwendung eines Deserialisierers einer SERDES-Zelle verwendet, wobei das Datenwort eine Mehrzahl von Bits aufweist und wobei die SERDES-Zelle ferner mit einem Abtasttakt zur Abtastung des Signals beaufschlagt wird, der höher als der Grundtakt ist. Schließlich werden die in der Bildungseinheit 145 gebildeten Werte bzw. das Datenwort einer Ermittlungseinheit 150 zum Ermitteln des Zeitpunktes der Flanke in dem Signal 132 unter Verwendung des Datenworts und des Grundtaktes in der Auswerteeinheit zugeführt, um den Zeitpunkt der Flanke in dem Signal 132 zu messen. Für eine Messung einer aktuellen Geschwindigkeit des Fahrzeugs 105 wird die vorstehend genannte Vorgehensweise mehrfach hintereinander wiederholt, sodass durch die jeweilige Ermittlung der Abstände des Fahrzeugs 105 zum Verkehrsüberwachungsgerätes 100 bei Kenntnis der zwischen den Messungen vergangenen Zeit die Geschwindigkeit des Fahrzeugs 105 zurückgerechnet werden kann.

Um nun eine sehr präzise Messung der Geschwindigkeit des Fahrzeugs 105 durch das Verkehrsüberwachungsgerät 100 zu ermöglichen, ist eine präzise Ermittlung des Abstandes zwischen dem Verkehrsüberwachungsgerät 100 und dem Fahrzeug 105 erforderlich. Dies ist insbesondere darin begründet, dass die Messungen des Verkehrsüberwachungsgeräts 100 meist zur Verhängung von Bußgeldern oder der Einleitung von Strafverfahren bei der Erkennung einer Übertretung von Geschwindigkeitsvorschriften verwendet werden und somit hohe Anforderungen an die Gerichtsverwertbarkeit gestellt sind. Ein besonderes Augenmerk ist deshalb auf die Messung des Zeitpunktes des eintreffenden Empfangssignals 132 zu richten, der aufgrund der meist kurzen Abstände zwischen dem Verkehrsüberwachungsgerät 100 und dem Fahrzeug 105 bei einer hohen Laufzeit mit Lichtgeschwindigkeit von zentraler Bedeutung ist. Wie eingangs bereits ausgeführt wurde, treten bei einigen Ansätzen Probleme in Bezug auf eine einfache Umsetzung bzw. höheren Implementierungsaufwand auf, die durch die hier vorgestellte Vorgehensweise vermindert oder behoben werden.

Für die Zeitauswertung von in Signalen auftretenden Flanken oder Signalsprüngen kann daher zumindest eine SERDES-Zelle, bzw. genauer ein Deserialisierer einer solchen SERDES-Zelle, verwendet werden, wie sie beispielsweise FPGAs für eine schnelle Datenübertragung zwischen zwei Schaltkreisen auf einer Baugruppe besitzen. Diese Zellen wandeln einen ausgehenden Datenstrom von parallelen Daten in serielle Daten (SERrialisierer) und einen eingehenden Datenstrom von seriellen Daten in parallele Daten um (DESserialisierer), woraus sich auch der Namen der Zellen als SER(rialisierer)/ DES(serialisierer)-Zelle ableitet.

Eine SERDES-Zelle als Eingang ist ein Schieberegister, mit dem ein serielles Eingangssignal mit einem schnellen Takt (Abtasttakt) abtastet wird. Der Inhalt des Schieberegisters wird mit einem langsameren Takt (Grundtakt) parallel ausgegeben. Eine SERDES-Zelle als Ausgang ist ein Schieberegister, das mit einem langsamen Takt parallel geladen wird, und dessen Daten dann mit dem schnellen Takt ausgetaktet werden. Die Wandlung kann in gängigen FPGA-Technologien in Verhältnissen von 1:4 bis 1:14 Bit erfolgen. 1:4 bedeutet vier parallele Bit werden auf eine serielle Leitung gewandelt bzw. umgekehrt. Die Frequenz der parallelen Daten wird für die seriellen Daten entsprechend des Wandlungsverhältnisses vervielfacht. Um das Taktverhältnis zwischen seriellen und parallelen Daten nochmals zu verdoppeln, besteht die Möglichkeit, den seriellen Datenstrom mit beiden Flanken des schnellen Taktes auszugeben bzw. abzutasten. Es werden sogenannte DoubleDataRate-FlipFlops -DDR-FFs - verwendet.

In einer Auswerteeinheit wie beispielsweise der Auswerteeinheit 125 in der Fig. 1, kann in einer Schaltung oder einem FPGA die Zeit zwischen zwei Pulsen und die Pulsbreite auf einem Signal gemessen werden. Für den hier zunächst beschriebenen Fall sind die Pulse positiv. Die Pulssignale bzw. das Signal, das dem Empfangssignal 132 entspricht, wird hierbei zunächst (beispielsweise im FPGA) digitalisiert. Dazu werden die SERDES-Zellen als Deserialisierer benutzt. Sie wandeln das serielle Eingangssignal in einen mehrbittigen Wert und liefern so den Inhalt der Eingangsschieberegisterkette mit dem langsamen Takt der parallelen Daten.

Fig. 2 zeigt ein Diagramm mit mehreren Signalverläufen, um die prinzipielle Funktionsweise des hier vorgestellten Ansatzes zu erläutern. Die Fig. 2 zeigt in diesem Zusammenhang ein Signalspiel für ein Deserialisierungsverhältnis von 1:4. In der Fig. 2 ist ein Signalverlauf dargestellt, in dem bei einem Eintreffen eines Empfangssignal 132 ein Signalsprung bzw. Flanke 200 erfolgt, wobei dieser Signalsprung bzw. Flanke 200 bei einem Wert von "Low" bzw. logisch 0 einem noch nicht eingetroffenen reflektierten Laserimpuls 130' entspricht und der Wert dieses Signals bei einem Eintreffen des reflektierten Laserimpulses 130' an der Lasereinheit 120 auf den Wert "High" bzw. logisch 1 springt. Der Einfachheit halber soll im Folgenden das dem reflektierten Laserimpuls 130' entsprechende Signal selbst mit dem Bezugszeichen 132 bezeichnet werden. In dem in der Fig. 2 im Signalverlauf darunter dargestellten Teildiagramm ist der (schnelle) Abtasttakt 205 und in einem weiteren Teildiagramm darunter der Grundtakt 210 der elektronischen Schaltung wiedergegeben. In dem untersten Teildiagramm aus der Fig. 2 ist eine Abfolge von Datenworten dargestellt, wie sie bei der Beaufschlagung einer SERDES-Zelle bzw. des Deserialisierers einer SERDES-Zelle mit dem Signal 132, dem Abtasttakt 205 und dem Grundtakt erhalten wird. Aus den Datenworten 220 ist herbei erkennbar, das bei einem Anliegen eines Wertes von logisch 0 am (seriellen) Eingang des Deserialisieres dieser Wert von logisch 0 mit dem Abtasttakt abgetastet wird und je Abtastwert des Signals 132 ein entsprechender Wert von logisch 0 an der betreffenden Stelle im Datenwort 220 abgelegt wird. Nachdem der Abtasttakt dem 4-fachen des Grundtakts entspricht, ist die Auslegung des Deserialisierers derart gewählt, dass ein 4-Bit breites Datenwort ausgegeben wird, wobei die Lägen des Datenwortes hier nur beispielhaft gewählt ist, es können auch andere Längen des Datenwortes 220 von der SERDES-Zelle bzw. dem Deserialisierer der SERDES-Zelle ausgegeben werden, wobei dann auch ein entsprechendes Verhältnis zwischen dem Abtasttakt 205 und dem Grundtakt 210 zu wählen ist. Aus der Darstellung des untersten Teildiagramms ist ferner erkennbar, dass während der ersten beiden Zyklen des Grundtaktes 210 kein Signalsprung des Signals 132 erfasst wird, sodass das Datenwort 220 jeweils die Werte "0000" und "0000" aufweist.

Während des dritten Zyklus des Grundtaktes 210 ist in dem obersten Teildiagramm aus der Fig. 1 ein Pegelwechsel im Signal 132 zu erkennen, der durch den Deserialisierer der SERDES-Zelle erkannt wird. Hierbei wird durch den Deserialisierer der SERDES-Zelle bei der Abtastung des Signals 132 mit dem Abtasttakt 205 der Signalsprung bzw. Flanke 200 vom Wert logisch 0 auf den Wert logisch 1 zwischen dem zweiten und dritten Zyklus des Abtasttaktes 205 im dritten Zyklus des Grundtaktes 210 detektiert, sodass bei der Seriell-Parallal-Wandlung des Deserialisierer der SERDES-Zelle in ein 4-bit-Datenwort 220 im dritten Zyklus des Grundtaktes 210 ein Wort von "0011" ausgegeben wird. In den nachfolgenden Grundtakten 210 wird wiederum bei der Abtastung des Signals 132 mit dem Abtasttakt 205 kein Signalsprung mehr erkannt, sodass jeweils ein den Wert des Signals 132 zu jedem der Zyklen des Abtasttaktes 205 repräsentierender Wert an die betreffende Stelle des Datenwortes 220 geschrieben wird, sodass in diesen Zeitpunkten Datenworte von "1111" ausgegeben werden. Bei einer Auswertung des Zeitpunktes eines Signalsprungs im Signal 132 kann somit der Abtasttakt 205 bzw. die Zyklen des Abtasttaktes 205, der Grundtakt 210 bzw. die Zyklen des Grundtaktes 210 sowie die jeweiligen Datenworte 220 verwendet werden, um den Zeitpunkt des Signalsprungs im Signal 132 sehr präzise erfassen zu können; zumindest deutlich präziser, als es bei der alleinigen Verwendung des Grundtaktes 210 möglich wäre.

Die parallelen Ausgangsdaten bzw. die Datenworte 220 werden somit nach Pegelwechseln untersucht, um eine Flanke im Signal 132 zu erkennen. Die Position des Pegelwechsels in den parallelen Daten beinhaltet die Zeitinformation. Diese kann ausgewertet werden. Mit Hilfe eines Grobzählers , der mit dem langsamen Takt des Grundtaktes 210 der parallelen Daten arbeitet und die Zyklen des Grundtaktes 210 bei einer bekannten Periodendauer des Grundtaktes 210, zählt, ist der Zeitpunkt des Eintreffens eines Pegelwechsels bestimmbar. Zugleich sollte jedoch auch die Periodendauer des Abtasttaktes 205 bekannt sein, da diese zur Ermittlung des Zeitpunktes der Flanke 200 innerhalb einer Periodendauer eines Grundtaktes 210 durch die Position des Signalwertwechsels im Datenwort 220 verwendet werden sollte.

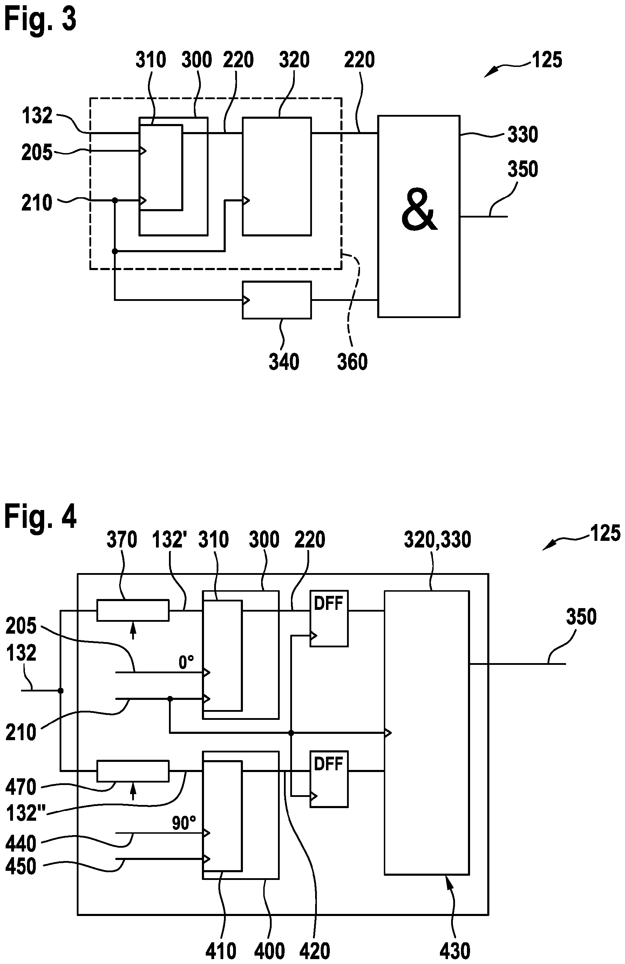

Fig. 3 zeigt ein Blockschaltbild eines prinzipiellen Aufbaus einer Auswerteeinheit 125 für eine Zeitmessung in einer sehr einfachen Form. Hierbei wird das Signal 132, der Abtasttakt 205 sowie der Grundtakt 210 einer SERDES-Zelle 300, speziell dem Desierialisierer 310 der SERDES-Zelle 300 zugeführt, der dann die Datenworte 220 ermittelt und einer Flankenauswertungseinheit 320 zuführt, welcher ebenfalls der Grundtakt 210 zugeführt wird. In der Flankenauswertungseinheit 320 wird nun erkannt, dass im Signal 132 ein Signalsprung bzw. Flanke 200 gemäß der Darstellung aus Fig. 2 enthalten war, sodass die Datenworte 220 an einer Zeitermittlungseinheit 330 weitergegeben werden können, in der unter Berücksichtigung einer in einem Grobzähler 340 ermittelten Anzahl von vergangenen Zyklen des Grundtaktes sowie aus der Position eines Wechsels der Werte im Datenwort 220 eine Zeitinformation bzw. der Zeitpunkt 350 des Eintreffens der Flanke 200 bzw. des Signalsprungs im Signal 132 ermittelt werden kann. Die Zeitauflösung der Auswerteeinheit 125 entspricht in diesem Fall der Periodendauer des Abtasttaktes 205.

Für jede Flanke 200 wird mittels der SERDES-Zelle 300 bzw. des Deserialisierers 310 der SERDES-Zelle 300, der Flankenauswertungseinheit 320 (die zusammen einen Kanal 360 bilden) und dem Grobzähler 340 der Zeitpunkt 350 des Eintreffens der Flanke 200 im Signal 132 ermittelt. Der Ausgang der Flankenauswertungseinheit 320 ergibt zusammen mit dem Grobzähler 340 Eingangsdaten für die Ermittlung der Zeitinformation mit einer Zeitauflösung des schnellen Taktes bzw. Abtasttaktes 205, die beispielsweise synchron zum langsamen Takt bzw. Grundtakt 210 ist.

Zur Erhöhung der Zeitauflösung kann in einem weiteren Ausführungsbeispiel die SERDES-Zelle 300 bzw. der Deserialisierer 310 der SERDES-Zelle 300 mit beiden Flanken des Abtasttaktes 205 arbeiten, sodass die Zeitauflösung der Auswerteeinheit 125 verdoppelt wird. Die Bitbreite der Datenworte 220 wird dadurch ebenfalls verdoppelt.

Zur Erhöhung der Auflösung können in einem weiteren Ausführungsbeispiel pro Eingangssignal 132 zwei SERDES-Zellen bzw. deren Deserialisierer verwendet werden. Die zweite SERDES-Zelle bzw. deren Deserialisierer wird mit einem um 90° verschobenen schnellen Takt, d. h, Abtasttakt 205 betrieben. Der langsame Takt (d. h., der Grundtakt 210) der zweiten SERDES-Zelle ist beispielsweise entsprechend dem Derserialisierungsverhältnis (1:n → 90° /n) verschoben. Mit diesem Aufbau wird die mögliche Zeitauflösung der Auswerteeinheit 125 nochmals verdoppelt, wenn die SERDES-Zellen mit beiden Flanken des jeweiligen Abtasttaktes arbeiten.

Fig. 4 zeigt ein Blockschaltbild einer solchen Variante einer Auswerteeinheit 125 unter Verwendung von zwei SERDES-Zellen, d. h. einer SERDES-Zelle 300 und einer zweiten SERDES-Zelle 400, die je mit dem Signal 132 (in einer parallelen Signalzuführung) beaufschlagt werden. Um genauer zu sein, wird ein zweiter Deserialisierer 410 der zweiten SERDES-Zelle 400 mit dem Signal 132 beaufschlagt. Hierbei können der Aufbau und die Verschaltung der zweiten SERDES-Zelle 410 dem Aufbau und der Verschaltung der SERDES-Zelle 300 entsprechen. Die zweite SERDES-Zelle 400 bzw. der Deserialisierer 410 der zweiten SERDES-Zelle 400 stellt dann ein zweites Datenwort 420 bereit, welches (zusammen mit dem vom Deserialisierer 310 bereitgestellten Datenwort 220) einer Kombinationseinheit 430 zugeführt wird, die die Funktionen der Flankenauswertungseinheit 320 sowie der Zeitermittlungseinheit 330 implementiert, sodass der eine dem ermittelten Zeitpunkt 350 entsprechende Information ausgegeben wird. Um die Zeitauflösung der Zeitpunkterfassung der Flanke 200 in dem Signal 132 zu erhöhen, wird die zweite SERDES-Zelle 400 bzw. der zweite Deserialisierer 410 der zweiten SERDES-Zelle 400 mit einem im Vergleich zum Abtasttakt 205 phasenverschobenen zweiten Abtasttakt 440 beaufschlagt. Dadurch wird es möglich, Signalsprünge bzw. Flanken 200 mit einer Zeitauflösung zu erfassen, die höher ist als die Zeitauflösung , die nur mit dem Abtasttakt 205 allein unter Verwendung der steigenden und der fallenden Taktflanken im Abtasttakt 205 erreicht werden kann. Beispielsweise kann der zweite Abtasttakt 440 um 90°-phasenverschoben in Bezug zum Abtasttakt 205 sein. Auch kann die zweite SERDES-Zelle 400 bzw. der zweite Deserialisierer 410 mit einem zum Grundtakt 210 phasenverschobenen zweiten Grundtakt 450 getaktet sein, um das zweite Datenwort 420 auszugeben. Das Ergebnis der Zeitauswertung in der Kombinationseinheit 430 wird dagegen beispielsweise auf den unverschobenen langsamen Takt, d. h. den Grundtakt 210 synchronisiert. Mit einer derartigen Modifikation der (Mess-) Kanals 360 zu einem erweiterten (Mess-) Kanal 460 lässt sich somit eine deutliche Steigerung (Verdopplung) der Zeitauflösung des Zeitpunktes eines aufgetretenen Signalsprungs bzw. einer Flanke 200 in dem Signal 132 erreichen.

Ferner kann auch gemäß einem optionalen Ausführungsbeispiel das Datenwort 220 und/oder das zweite Datenwort 420 vor dem Zuführen in die Kombinationseinheit 430 mittels (je) eines D-Flip-Flops (DFF) zwischengespeichert werden, welche(s) mit dem Grundtakt 210 getaktet ist/sind. Hierdurch kann eine zeitgleiche Ankunft der Datenworte 220 und 420 an der Kombinationseinheit 430 sichergestellt werden, sodass undefinierte Zustände auf Datenleitungen an oder in der Kombinationseinheit vermieden werden können.

Weiterhin kann mit Hilfe von Verzögerungsgliedern 370, 470 wie z.B. der Zelle IDELAY2 von Xilinx eine Zeitverzögerung im ps-Bereich vor der Beaufschlagung des Deserialisierer 310, 410 der betreffenden SERDES-Zelle 300, 400 für jedes Eingangssignal bzw. Signal 132 individuell eingestellt werden. Es entstehen die Signale 132' bzw. 132" die sich vom Signal 132 dadurch unterscheiden, dass sie zeitlich individuell verzögert sind. Mit der individuellen Verzögerung des Signals 132 werden technologiebedingte und/oder umweltbedingte ungleiche Verzögerungen zwischen dem Eingang des Signals 132 an der Auswerteeinheit 125 und den Abtastpunkten der Deserialisierer 310, 410 ausgeglichen. Es wird eine maximal isochrone Abtastung des Signals 132 über alle verwendeten Deserialisierer 310, 410 ermöglicht, die zur Minimierung der differentiellen und integralen Nichtlinearität der Auswerteeinheit 125 und der ermittelten Zeitpunkte 350 führt. Das unterschiedliche Verhalten des Systems bei steigenden bzw. fallenden Flanken des Signals 132 kann durch die individuell einstellbaren Verzögerungsglieder 370, 470 optimiert für die steigende, für die fallende oder für beide Flanken des Signals 132 korrigiert werden. Die optimierte Korrektur für beide Flanken des Signals erzeugt unter Umständen eine höhere Ungenauigkeit (differentielle bzw. integrale Nichtlinearität) der Auswerteeinheit 125 wie die Optimierung auf eine Schaltflanke des Signals 132. Bei der Optimierung der Korrektur auf eine Schaltflanke des Signals 132 verringert sich unter Umständen die Messgenauigkeit (differentielle bzw. integrale Nichtlinearität) der anderen Flanke des Signals 132 der Auswerteeinheit 125 signifikant.

Die resultierenden parallelen Ausgangsdaten bzw. die Datenworte 220 bzw. 420 sind gemäß dem in der Fig. 4 dargestellten Systemaufbau durch die DFFs um einen langsamen 0°-Takt verzögert, da die parallelen Ausgangsdaten 420 der verschobenen SERDES-Zelle 400 auf den unverschobenen Takt (Grundtakt 210) synchronisiert werden. Dieser Aufbau ließe sich immer weiter verdoppeln um, noch höhere Zeitauflösungen der Auswerteeinheit 125 zu erreichen. Er hat aber in der (FPGA-)Technologie begrenzende Parameter. Es ist beispielsweise darauf zu achten, dass möglichst alle verwendeten Takte in einem Taktgenerator erzeugt werden, so dass der Jitter in allen Takten identisch ist. Weiterhin sollte der Taktgenerator eine entsprechend feingranulare Phasenverschiebung auf den verschiedenen Ausgangstakten ermöglichen. Gängige FPGA-Technologien bieten beispielsweise Taktgeneratoren mit bis zu acht Taktausgängen. Es besteht auch die Möglichkeit die Takte über einen externen Taktgenerator zu erzeugen. Dann sollte auf die Verteilung und die Laufzeit der Takte auf der Leiterplatte und im FPGA sehr genau geachtet werden.

Beispielsweise kann hierzu sowohl der Abtasttakt 205 als auch der Grundtakt 210 von einem, in der Fig. 4 nicht dargestellten und zur Auswerteeinheit 125 externen Taktgenerator (beispielsweise dem Taktgenerator 140 aus Fig. 1) erzeugt werden und der Grundtakt 210 aus dem Abtasttakt abgeleitet werden. Auch kann beispielsweise eine Phasenverschiebung in dem Taktgenerator vorgenommen werden, um den zweiten Abtasttakt 440 bzw. den zweiten Grundtakt 450 zu erhalten. Alternativ kann eine solche Bereitstellung von phasenverschobenen Takten auch innerhalb der Auswerteeinheit 125 durch ein entsprechend ausgebildetes Phasenverschiebungsglied erfolgen.

Mit jeder weiteren SERDES-Zelle wird ein beispielsweise ein weiterer Eingangspin am FPGA benötigt. Die Schaltschwellen jedes Eingangspins sind individuell, d. h. jeder Eingangspin schaltet für eine steigende bzw. eine fallende Flanke bei einem anderen Eingangsspannungspegel und damit zu einem anderen Zeitpunkt. Dadurch wird die differenzielle Nichtlinearität des Systems ungenauer. Es ist keine Gleichverteilung der Zeitinformationen mehr gegeben. Diese Problematik kann, wie bereits zuvor schon kurz angeführt, durch die Verwendung der Verzögerungsglieder 370, 470 kompensiert werden, in denen eine individuelle Einstellung von Verzögerungen bei der Weiterleitung eines entsprechend angeschlossenen Signals implementiert werden kann.

Beim Leiterplattenentwurf ist darauf zu achten, dass alle Eingangspins mit möglichst steilen Schaltflanken getrieben werden. Unter Umständen ist es sinnvoll, das auszuwertende Signal mit einem Eingangspin am FPGA einzufangen und via 1:n-Multiplexer asynchron auf n Ausgangspins (pro SERDES-Zelle ein Pin) auszugeben. Diese n Ausgangssignale werden auf der Leiterplatte direkt auf die Eingangspins der Messstufe rückgekoppelt. Die Ausgangspins des FPGAs können sehr steile Schaltflanken erzeugen und dadurch das oben beschriebene Verhalten minimieren.

Bei jedem Aufbau sollte darauf geachtet werden, dass das Deserialisierungsverhältnis in einem 2ⁿ-Vielfachen realisiert wird, um die Erweiterung des Grobzählers möglichst einfach zu gestalten.

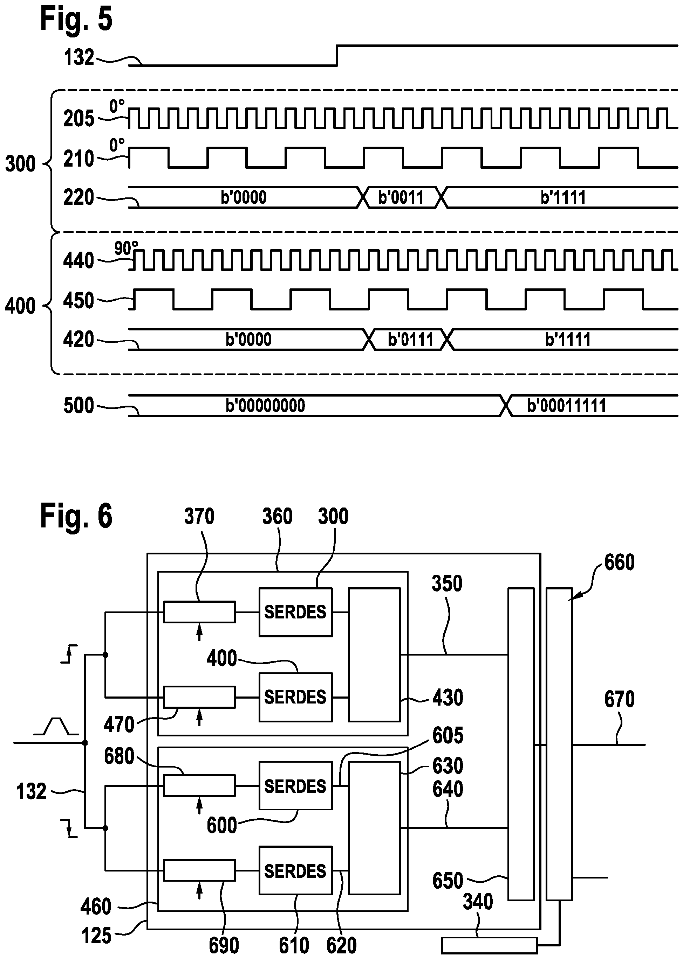

Fig. 5 zeigt ein Diagramm mit mehreren Signalverläufen, um die prinzipielle Funktionsweise der Auswerteeinheit 125 gemäß Fig. 4 zu erläutern. In dem obersten Teildiagramm wird der Signalverlauf des Signals 132 dargestellt, das den beiden SERDES-Zellen 300 und 400 zugeführt wird. Die drei darunter dargestellten Teildiagramme entsprechen den Signalverläufen des Abtasttaktes 205, des Grundtaktes 210 und den Datenworten 220, wie sie bereits mit Bezug zur Fig. 2 zur (ersten) SERDES-Zelle 300 gemäß der Darstellung aus der Fig. 3 (oder aus der Fig. 4) erläutert wurden. In den anschließenden drei weiteren Teildiagrammen werden nun die den Signalverläufen des zweiten (um 90° phasenverschobenen) Abtasttaktes 440, des zweiten (phasenverschobenen) Grundtaktes 210 und den Datenworten 420 dargestellt, wie sie bereits mit Bezug zur Fig. 4 zur zweiten SERDES-Zelle 400 erläutert wurden. Erkennbar ist hierbei, dass im dritten Zyklus des zweiten Grundtaktes 450, d. h. des phasenverschobenen Grundtaktes 450, das zweite Datenwort 420 nun nicht mehr den Wert "0011", sondern den Wert "0111" aufweist. Dies ist darauf zurückzuführen, dass nun der Signalsprung bzw. Flanke 200 durch die Abtastung mit dem zweiten (d. h., dem 90°-phasenverschobenen) Abtasttakt 440 als etwas früher aufgetreten erkannt wurde, als durch die Verwendung des Abtasttaktes 205. Wird nun aus dem Datenwort 220 und dem zweiten Datenwort 420 in der Kombinationseinheit 430 der Zeitpunkt des aufgetretenen Signalsprungs bzw. der Flanke 200 ermittelt, kann hierzu beispielsweise eine abwechselnde Verknüpfung der einzelnen Werte des Datenwortes 220 und des zweiten Datenwortes 420 zu einem Gesamtwort 500 erfolgen, sodass jede Stelle dieses Gesamtwortes 500 eine vordefinierte vergangenen Zeitspanne repräsentiert. Auf diese Weise kann eine sehr präzise Ermittlung des Zeitpunktes 350 des Auftretens einer Flanke 200 in dem Signal 132 erreicht werden.

Um nun eine weitere Verbesserung der Erkennungsgenauigkeit der Auswerteeinheit 125 zu erreichen kann auch die gemäß Fig. 4 dargestellte Struktur nochmals erweitert werden, wie sie mit Bezug zur Fig. 6 näher beschrieben ist.

Fig. 6 zeigt ein Blockschaltbild eines prinzipiellen Aufbaus einer Auswerteeinheit 125 gemäß einem Ausführungsbeispiel für eine Zeitmessung in einer erweiterten Form. Im Unterschied zur der Auswerteeinheit 125 aus Fig. 4 kann beispielsweise ein weiterer Kanal 460 vorgesehen sein, in dem die SERDES-Zellen nun auf fallende Signalsprünge bzw. Flanken 200 sensitiv sind, also beispielsweise einen Wechsel des Signals 132 von einem Pegel logisch 1 auf einen Pegel logisch 0. Hierzu kann der weiterer Kanal 460 eine weitere SERDES-Zelle 600, die bis auf die Flankensensitivität der SERDES-Zelle 300 entspricht und ebenfalls analog mit dem Signal 132, dem Abtasttakt 205 und dem Grundtakt 210 beschaltet wird, um weitere Datenworte 605 auszugeben. Parallel kann der weitere Kanal 460 eine zusätzliche SERDES-Zelle 610, die bis auf die Flankensensitivität der zweiten SERDES-Zelle 400 entspricht und ebenfalls analog mit dem Signal 132, dem zweiten (phasenverschobenen) Abtasttakt 440 und dem zweiten (phasenverschobenen) Grundtakt 450 beschaltet wird, um zusätzliche Datenworte 620 zu erhalten. Aus dem weiteren Datenwort 605 und dem zusätzlichen Datenwort 620 kann dann in einer der Kombinationseinheit 430 entsprechenden weitere Kombinationseinheit 630 eine Flankenauswertung über das Auftreten einer fallenden Flanke erfolgen und eine entsprechende Zeitinformation 640 an eine Gesamtflankenauswertungseinheit 650 gesandt werden, die dann eine Ermittlung eines Signalsprungs oder einer Flanke 200 entweder mit steigender Signalflanke oder mit fallender Signalflanke erfassen kann. In einer nachfolgenden Zeitpunktermittlungseinheit 660 kann dann die betreffende Information über einen Zeitpunkt der aufgetretenen Flanke 200 vorgenommen werden, wobei wiederum eine Information aus dem Grobzähler 340, der eine Zyklenzahl bzw. eine Periodendauer des Grundtaktes 210 bereitstellt, um hierdurch und unter Verwendung der Informationen aus den Datenworten 220, 420, 605 und/oder 620 den Zeitpunkt des Auftretens der Flanke 200 im Signal 132 sehr präzise bestimmen zu können. Zur Angleichung der Laufzeiten der Signale in einer Hardware-Schaltung können ferner auch in diesem Ausführungsbeispiel, wie in der Fig. 6 dargestellt, Verzögerungsglieder verwendet werden, wie sie bereits in Bezug zum Ausführungsbeispiel aus der Fig. 4 näher beschrieben wurden. Die Verzögerungsglieder 370, 470 im Kanal 360 (vgl. Fig. 6) werden beispielsweise für steigende Flanken des Signals 132 und die Verzögerungsglieder 680, 690 im Kanal 460 werden beispielsweise für fallende Flanken des Signals 132 optimiert eingestellt. Dadurch wird eine maximal genaue Abtastung beider Flanken des Signals 132 erreicht.

Zusammenfassend kann daher ausgeführt werden, dass gemäß dem hier vorgestellten Ansatz die Zeitmessung unter Verwendung von Deserialisierern der digitalen Schaltkreise erfolgt. In modernen digitalen Schaltkreisen existieren in den IO-Zellen Serialisierer/Deserialisierer (SERDES), die für die hier vorgestellten Zwecke sehr gut verwendet werden können. Mit Hilfe dieser Zellen sind schnelle Datenübertragungen mit wenigen Leitungen möglich. Dazu werden im Serialisierer parallele Daten seriell gewandelt und mit einer hohen Bitrate ausgegeben. Der Deserialisierer empfängt den Bitdatenstrom und wandelt die Daten zurück in parallele Worte mit geringerer Geschwindigkeit. Der Deserialisierer tastet ein Eingangssignal mit einem sehr hohen Takt ab. Diese Eigenschaft wird für die Zeitmessung genutzt. An den Eingang eines oder mehrerer Deserialisierer wird ein zu bewertendes Eingangssignal angelegt. Dieses Signal wird mit der hohen Deserialisierungstaktrate abgetastet und parallel am Ausgang des Deserialisierers mit dem Systemtakt ausgegeben. Durch die Verwendung beider Flanken des Abtasttaktes im Deserialisierer und die Ansteuerung die der Deserialisierer mit phasenverschobenen Abtasttakten wird eine Zeitauflösung mit einem Vielfachen des Abtasttaktes erreicht. Der Datenstrom der Deserialisierer kann geeignet weiterverarbeitet werden. Parallel zum Deserialisierer existiert ein Grobzähler der mit dem Systemtakt arbeitet. Dieser Takt wird durch den oder die Deserialisierer entsprechend ihrer seriellparallel Wandlung und Verschaltung weiter aufgelöst, wobei auch eine Optimierung der Eingangsstufen des Eingangssignals für eine Flanke vorgenommen werden kann. Das hat zur Folge, dass für das Abtasten eines Signals jeweils eine oder mehrere Eingangsstufen verwendet werden. In der Flankenauswertung sollten die korrekten Zeitwerte für die steigende bzw. fallende Flanke korrekt berücksichtigt werden.

Das Verhalten der Schaltung ist von der Technologie und Umwelteinflüssen abhängig. Um die Technologieabhängigkeit auszugleichen sollte die Schaltung kalibriert werden. Die Verzögerung der Verzögerungsglieder ist beispielsweise dynamisch änderbar. Dadurch kann die Kalibrierung in jedem eingesetzten IC bzw. Schaltung individuell angepasst werden. Der Einfluss von Umweltfaktoren kann ebenfalls über die dynamische Änderung der Verzögerung der Verzögerungsglieder ausgeglichen werden. Dies kann technologieabhängig ggf. während des Betriebs der Schaltung erfolgen.

Die vorstehend beschriebene Fig. 6 zeigt einen möglichen Aufbau der Abtastung eines Einzelsignals 132. Jeder Einzelkanal mit je einer SERDES-Zelle bzw. einem Deserialisierer kann technologieabhängig beliebig oft instanziiert werden. Dadurch wird die Granularität der Zeitauflösung weiter erhöht, bis die technologische Grenze erreicht ist. Die Anzahl der Instanziierungen kann für die Erfassung der steigenden und der fallenden Flanke des Signals 132 verschieden sein. Die beiden Flanken können hierdurch mit unterschiedlicher Auflösung erfasst werden. Zwei Eingangsstufen werden für die Bestimmung der Zeitinformationen eines Signals verwendet.

Die Einzelsignalabtastung kann technologieabhängig beliebig oft benutzt werden, um mehrere Signale abzutasten. In jeder Eingangsstufe einer Einzelsignalabtastung ist die Anzahl der realisierten Einzelkanäle mit je einer SERDES-Zelle bzw. einem Deserialisierer frei. Sie kann für jedes erfasste Einzelsignal individuell festgelegt werden. Die Flankenzeitpunkte der verschiedenen Signale werden zueinander in der Zeitauswertung in Beziehung gesetzt bzw. ausgegeben. Jeder Einzelkanal wird für die jeweilig zu erfassende Flanke optimal kalibriert. Die Kalibrierung und Konfiguration der verschiedenen Verzögerungsglieder erfolgt für jedes Modul individuell und hat damit die maximale Flexibilität. Die Konfiguration kann technologieabhängig zur Laufzeit erfolgen und anhand von Umwelteinflüssen nachgeführt werden.

Der Vorteil des hier vorgestellten Ansatzes kann darin gesehen werden darin, dass mit Hilfe digitaler Schaltkreise (z. B. programmierbare Logik - FPGAs) viele Eingangssignale mit einem IC abgetastet und zueinander gemessen werden können. Gegenüber separaten Zeitmesschaltkreisen besteht der Vorteil in den Eingangssignalen viele Pegelwechsel in kurzer Zeit auch zwischen verschiedenen Eingangssignalen bewerten zu können. Eine Kalibrierung ist für den Ausgleich von Umwelteinflüssen möglich. Da in Systemen zur digitalen Signalverarbeitung häufig programmierbare digitale Schaltkreise eingesetzt werden, ist die Zeitmessung ohne weitere integrierte Schaltkreise (ICs) möglich.

Der hier vorgestellte Ansatz kann somit dahingehend als digitale Schaltung entworfen sein, mit deren Hilfe ein digitales Eingangssignal zeitlich sehr hochgranular aufgelöst werden kann. Die Zeitauflösung soll deutlich über der maximal möglichen Zeitauflösung des Systemtaktes (d. h., dem Grundtakt) und des Abtasttaktes der digitalen Schaltung liegen. Bei Verwendung der Schaltung kann der Abstand zwischen zwei Flanken oder der Zeitpunkt der Flanken eines Eingangssignals ermittelt werden. Bei Verwendung von zwei oder mehr Schaltungen für verschiedene Eingangssignale können die zeitlichen Abstände zwischen den Flanken der Eingangssignale oder die Zeitpunkte der Flanken der Eingangssignale ermittelt werden. Die Eingänge der Schaltung können explizit für steigende und für fallende Flanken optimiert sein, sodass die unterschiedliche technologische Erfassung von steigenden und fallenden Flanken ausgeglichen wird. Für die Erfassung von steigenden und fallenden Signalflanken sind je Eingangssignal zwei Schaltungen zu verwenden.

Die ermittelten Messwerte können z. B. für die Laufzeit von Licht wie dem Laserimpuls 130 zwischen Sender (unter Berücksichtigung einer Reflektion am Fahrzeug) und Empfänger verwendet werden. Dadurch ist eine Entfernung ermittelbar. Die Schaltung kann vorteilhafterweise in programmierbarer Logik und/oder anwenderspezifischen Schaltkreisen implementierbar sein. Für verschiedene Sensoranwendungen ist es günstig die Zeit zwischen den Flanken digitaler Eingangssignale in digitalen elektronischen Schaltungen und integrierten Schaltkreisen (Integrated Circuit - IC) zu messen. Dabei können die zeitlichen Beziehungen der Flanken in einem bzw. auch zwischen mehreren Eingangssignalen ermittelt werden. Die Auflösung über den Systemtakt / Grundtakt der digitalen Schaltung ist oft zu gering oder der Systemtakt der digitalen Schaltung kann bzw. soll nicht derart erhöht werden, um eine entsprechende zeitliche Auflösung zu erreichen. Es sollte daher eine digitale Schaltung entworfen werden, die gegenüber dem Systemtakt / Grundtakt eine sehr hohe zeitliche Auflösung realisiert. Die Schaltung kann beispielsweise in einmal und mehrmals programmierbaren digitalen ICs (z.B. FPGAs) und in anwenderspezifischen ICs (z.B. ASICs) implementiert werden.

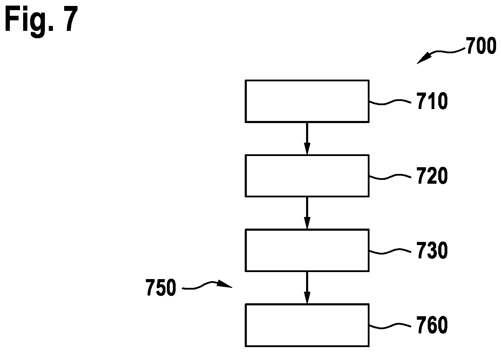

Fig. 7 zeigt ein Ablaufdiagramm eines Ausführungsbeispiels des hier vorgestellten Ansatzes als Verfahren 700 zur Messung eines Zeitpunkts einer Flanke in einem Signal. Das Verfahren 700 umfasst einen Schritt 710 des Einlesens des Signals und eines Grundtaktes zum Betrieb einer digitalen Auswerteeinheit zur Auswertung des Zeitpunktes der Flanke. Ferner umfasst das Verfahren 700 einen Schritt 720 des Bildens eines das Signal repräsentierenden Datenworts unter Verwendung eines Deserialisierers einer SERDES-Zelle, wobei das Datenwort eine Mehrzahl von Bits aufweist und wobei die SERDES-Zelle ferner mit einem Abtasttakt zur Abtastung des Signals beaufschlagt wird, der höher als der Grundtakt ist. Schließlich umfasst das Verfahren 700 einen Schritt 730 des Ermittelns des Zeitpunktes der Flanke in dem Signal unter Verwendung des Datenworts und des Grundtaktes in der Auswerteeinheit, um den Zeitpunkt der Flanke in dem Signal zu messen.

In einer weiteren Variante wird ein Ablaufdiagramm für ein Verfahren 750 zu Bestimmung einer Laufzeit eines Testsignals vorgestellt, wobei ein Startzeitpunkt eines auszusendenden Testsignals und/oder ein Empfangszeitpunkt eines empfangenen Testsignals unter Verwendung der Schritte einer hier vorgestellten Variante eines Verfahrens zur Messung eines Zeitpunkts einer Flanke in einem Signal gemessen wird, wobei ferner in einem Schritt 760 des Bestimmens die Laufzeit unter Verwendung des Startzeitpunkts und des Empfangszeitpunkts bestimmt wird.

Zusammenfassend lässt sich feststellen, dass durch den hier vorgestellten Ansatz eine einfache hochauflösende Zeitmessung im FPGA möglich ist. Um die steigenden und fallenden Flanken eines Eingangssignals mit ähnlicher Qualität zu messen, kann je ein Messkanal, optimiert für die Messung der jeweiligen Flanke, implementiert werden.

Die Verwendung von Verzögerungsgliedern wurde im Digitaldesign einstellbar vorgesehen. Die Verzögerung kann, wenn notwendig, daher auch dynamisch eingestellt werden. Dadurch ist eine Kalibrierung der Messkanäle im Betrieb möglich. Ein Ausgleich von baugruppen- bzw. umweltspezifischen Parametern der Messkanäle ist so möglich. In dem hier vorgestellten Ansatz sind nur zwei Kanäle implementiert worden. Es ist jedoch ebenfalls denkbar, noch deutlich mehr messende Kanäle zu implementieren.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Verfahren (700) zur Ermittlung eines Zeitpunkts einer Flanke (200) in einem Signal (132), wobei das Verfahren (700) die folgenden Schritte aufweist:
- Einlesen (710) des Signals (132) und eines Grundtaktes (210) zum Betrieb einer digitalen Auswerteeinheit (125) zur Auswertung des Zeitpunktes der Flanke (200);
- Bilden (720) eines das Signal (132) repräsentierenden Datenworts (220) unter Verwendung eines Deserialisierers (310) einer SERDES-Zelle (300), wobei das Datenwort (220) eine Mehrzahl von Bits aufweist und wobei die SERDES-Zelle (300) ferner mit einem Abtasttakt (205) zur Abtastung des Signals (132) beaufschlagt wird, der höher als der Grundtakt (210) ist, wobei zur Abtastung des Signals (132) eine Flanke oder zwei Flanken des Abtasttaktes (205) verwendet werden; und
- Ermitteln (730) des Zeitpunktes der Flanke (200) in dem Signal (132) unter Verwendung des Datenworts (220) und des Grundtaktes (210) in der digitalen Auswerteeinheit (125), **dadurch gekennzeichnet, dass** im Schritt (720) des Bildens eines das Signal (132) repräsentierenden zweiten Datenworts (420) dieses zweite Datenwort (420) unter Verwendung eines zweiten Deserialisierers (410) einer zweiten SERDES-Zelle (400) gebildet wird, das eine Mehrzahl von Bits aufweist, wobei die zweite SERDES-Zelle (400) mit einem zum Abtasttakt (205) um einen vorbestimmten Phasenwinkel verschobenen zweiten Abtasttakt (440) zur Abtastung des Signals (132) beaufschlagt wird, der höher als der Grundtakt (450) ist, wobei die zweite SERDES-Zelle (400) mit einem zum Grundtakt (210) um einen vorbestimmten Phasenwinkel verschobenen zweiten Grundtakt (450) beaufschlagt wird und wobei im Schritt (730) des Ermittelns der Zeitpunkt ferner unter Verwendung des zweiten Datenworts (420) ermittelt wird und im Schritt (730) des Ermittelns die Werte des Datenwortes (220) und des zweiten Datenwortes (420) abwechselnd zu Werten eines Gesamtwortes (500) zusammengefügt werden, wobei der Zeitpunkt ferner unter Verwendung des Gesamtwortes (500) ermittelt wird.

2. Verfahren (700) gemäß Anspruch 1, **dadurch gekennzeichnet, dass** im Schritt (720) des Bildens ein Synchronisieren des Abtasttaktes (205) mit dem Grundtakt (210) erfolgt, bevor die SERDES-Zelle (300) mit dem Abtasttakt (205) beaufschlagt wird, wobei der Abtasttakt (205) und der Grundtakt (210) von einem Taktgenerator bereitgestellten Signal abgeleitet wurden.

3. Verfahren (700) gemäß einem der vorangegangenen Ansprüche, **dadurch gekennzeichnet, dass** im Schritt (720) des Bildens ferner ein das Signal (132) repräsentierendes weiteres Datenwort (605) unter Verwendung eines Deserialisierers einer weiteren SERDES-Zelle (600) gebildet wird, wobei das weitere Datenwort (605) eine Mehrzahl von Bits aufweist und wobei die weitere SERDES-Zelle (600) ferner mit einem Abtasttakt (205) zur Abtastung des Signals (132) beaufschlagt wird, der höher als der Grundtakt (210) ist und wobei die SERDES-Zelle (300) und die weitere SERDES-Zelle (600) auf je unterschiedliche Vorzeichen von Flankensteilheiten im Signal (132) sensitiv sind, und wobei im Schritt (730) des Ermittelns der Zeitpunkt der Flanke (200) in dem Signal (132) unter Verwendung des weiteren Datenworts (605) und des Grundtaktes (210) in der Auswerteeinheit (125) ermittelt wird, um den Zeitpunkt der Flanke (200) in dem Signal (132) zu messen.

4. Verfahren (700) gemäß Anspruch 3, **dadurch gekennzeichnet, dass** im Schritt (720) des Bildens die weitere SERDES-Zelle (600) ausgebildet ist, um ein weiteres Datenwort (605) auszugeben, das eine vom Datenwort (220) unterschiedliche Bitzahl aufweist.

5. Verfahren (700) gemäß einem der Ansprüche 3 oder 4, **dadurch gekennzeichnet, dass** im Schritt (720) des Bildens ein das Signal (132) repräsentierendes zusätzliches Datenwort (620) unter Verwendung eines Deserialisierers einer zusätzlichen SERDES-Zelle (610) gebildet wird, das eine Mehrzahl von Bits aufweist, wobei die zusätzliche SERDES-Zelle (610) mit einem zum Abtasttakt (205) um einen vorbestimmten Phasenwinkel verschobenen zusätzliche Abtasttakt zur Abtastung des Signals (132) beaufschlagt wird und wobei im Schritt (730) des Ermittelns der Zeitpunkt ferner unter Verwendung des zusätzlichen Datenworts (620) ermittelt wird.

6. Verfahren (700) gemäß einem der vorangegangenen Ansprüche, **dadurch gekennzeichnet, dass** das Signal im Schritt (710) des Einlesens vor dem Zuführen zu mindestens einer der SERDES-Zellen (300, 400, 600, 610) verzögert wird.

7. Verfahren (750) zur Bestimmung einer Laufzeit und/oder einer Pulsbreite eines Testsignals (130, 130'), wobei ein Zeitpunkt und/oder Zeitpunkte einer steigenden und/oder einer fallenden Flanke eines auszusendenden Testsignals (130) und/oder ein Zeitpunkt und/oder Zeitpunkte einer steigenden und/oder einer fallenden Flanke eines empfangenen Testsignals (130') unter Verwendung der Schritte (710, 720, 730) eines Verfahrens (700) gemäß einem der Ansprüche 1 bis 6 ermittelt wird, wobei ferner in einem Schritt (760) des Bestimmens die Laufzeit unter Verwendung des Zeitpunkts der steigenden und/oder fallenden Flanke bestimmt wird.

8. Verfahren (800) gemäß Anspruch 7, wobei die Laufzeit eines Laserimpulses (130, 130') eines Verkehrsüberwachungsgerätes (100) als Testsignal (130, 130') bestimmt wird.

9. Auswerteeinheit (125) zur Messung eines Zeitpunkts einer Flanke (200) in einem Signal (130), wobei die Auswerteeinheit (125) Einrichtungen (135, 140, 150, 300, 320, 330) aufweist, die ausgebildet sind, um die Schritte (710, 720, 730) eines Verfahren (700) gemäß den Ansprüchen 1 bis 6 auszuführen und/oder anzusteuern.

10. Auswerteeinheit (125) gemäß Anspruch 9, **dadurch gekennzeichnet, dass** die Auswerteeinheit als digitaler integrierter Schaltkreis ausgebildet ist.

11. Auswerteeinheit (125) gemäß einem der Ansprüche 9 oder 10, **dadurch gekennzeichnet, dass** zumindest ein Takteingangsanschluss vorgesehen ist, um den Grundtakt (210) und/oder den Abtasttakt (205) der Auswerteeinheit (125) von außerhalb der Auswerteeinheit (125) zuzuführen.

## Claims

1. Method (700) for determining a time of a flank (200) in a signal (132), wherein the method (700) comprises the following steps:
- Reading (710) the signal (132) and a master clock rate (210) for operating a digital evaluation unit (125) for evaluating the time of the flank (200);
- Forming (720) a data word (220) representing the signal (132) using a deserializer (310) of a SERDES cell (300), wherein the data word (220) has a plurality of bits, and wherein a sampling clock rate (205) is also applied to the SERDES cell (300) for sampling the signal (132), which sampling clock rate is higher than the master clock rate (210), wherein one flank or two flanks of the sampling clock rate (205) are used for sampling the signal (132); and
- Determining (730) the time of the flank (200) in the signal (132) using the data word (220) and the master clock rate (210) in the digital evaluation unit (125), **characterized in that,** in the step (720) of forming a second data word (420) representing the signal (132), this second data word (420) is formed using a second deserializer (410) of a second SERDES cell (400), which second data word has a plurality of bits, wherein a second sampling clock rate (440) shifted by a predetermined phase angle in relation to the sampling clock rate (205), which sampling clock rate is higher than the master clock rate (450), is applied to the second SERDES cell (400) for sampling the signal (132), wherein a second master clock rate (450) shifted by a predetermined phase angle in relation to the master clock rate (210) is applied to the second SERDES cell (400), and wherein, in the step (730) of determining, the time is furthermore determined using the second data word (420) and, in the step (730) of determining, the values of the data word (220) and of the second data word (420) are combined alternately into values of an overall word (500), wherein the time is furthermore determined using the overall word (500).

2. Method (700) according to Claim 1, **characterized in that,** in the step (720) of forming, a synchronization of the sampling clock rate (205) with the master clock rate (210) takes place before the sampling clock rate (205) is applied to the SERDES cell (300), wherein the sampling clock rate (205) and the master clock rate (210) have been derived from a signal provided by a clock rate generator.

3. Method (700) according to either of the preceding claims, **characterized in that,** in the step (720) of forming, a further data word (605) representing the signal (132) is furthermore formed using a deserializer of a further SERDES cell (600), wherein the further data word (605) has a plurality of bits, and wherein a sampling clock rate (205) for sampling the signal (132) is furthermore applied to the further SERDES cell (600), which sampling clock rate is higher than the master clock rate (210), and wherein the SERDES cell (300) and the further SERDES cell (600) are each sensitive to different signs of flank slopes in the signal (132), and wherein, in the step (730) of determining, the time of the flank (200) in the signal (132) is determined in the evaluation unit (125) using the further data word (605) and the master clock rate (210) in order to measure the time of the flank (200) in the signal (132).

4. Method (700) according to Claim 3, **characterized in that,** in the step (720) of forming, the further SERDES cell (600) is designed to output a further data word (605) that has a different bit number than the data word (220).

5. Method (700) according to either of Claims 3 or 4, **characterized in that,** in the step (720) of forming, an additional data word (620) representing the signal (132) is formed using a deserializer of an additional SERDES cell (610), which additional data word has a plurality of bits, wherein an additional sampling clock rate, shifted by a predetermined phase angle in relation to the sampling clock rate (205), is applied to the additional SERDES cell (610) for sampling the signal (132), and wherein, in the step (730) of determining, the time is furthermore determined using the additional data word (620).

6. Method (700) according to any one of the preceding claims, **characterized in that** the signal is delayed in the step (710) of reading before it is fed to at least one of the SERDES cells (300, 400, 600, 610).

7. Method (750) for determining a transit time and/or a pulse width of a test signal (130, 130'), wherein a time and/or times of a rising and/or a falling flank of a test signal (130) to be transmitted and/or a time and/or times of a rising and/or a falling flank of a received test signal (130') is determined using the steps (710, 720, 730) of a method (700) according to any one of Claims 1 to 6, wherein, in a step (760) of determining, the transit time is furthermore determined using the time of the rising and/or falling flank.

8. Method (800) according to Claim 7, wherein the transit time of a laser pulse (130, 130') of a traffic monitoring device (100) is determined as a test signal (130, 130').

9. Evaluation unit (125) for measuring a time of a flank (200) in a signal (130), wherein the evaluation unit (125) has devices (135, 140, 150, 300, 320, 330), which are designed to carry out and/or control the steps (710, 720, 730) of a method (700) according to Claims 1 to 6.

10. Evaluation unit (125) according to Claim 9, **characterized in that** the evaluation unit is designed as a digital integrated circuit.

11. Evaluation unit (125) according to either of Claims 9 or 10, **characterized in that** at least one clock rate input connection is provided in order to feed the master clock rate (210) and/or the sampling clock rate (205) to the evaluation unit (125) from outside the evaluation unit (125).

## Revendications

1. Procédé (700) pour déterminer un instant d'un front (200) dans un signal (132), le procédé (700) présentant les étapes suivantes :
- lecture (710) du signal (132) et d'un signal d'horloge de base (210) pour faire fonctionner une unité d'évaluation (125) numérique pour l'évaluation du moment du front (200) ;
- formation (720) d'un mot de données (220) représentant le signal (132) en utilisant un désérialiseur (310) d'une cellule SERDES (300), le mot de données (220) présentant une pluralité de bits et la cellule SERDES (300) étant en outre soumise à une horloge de balayage (205) pour balayage du signal (132), laquelle est supérieure à l'horloge de base (210), un front ou deux fronts de l'horloge de balayage (205) étant utilisés pour balayage du signal (132) ; et
- détermination (730) du moment du front (200) dans le signal (132) en utilisant le mot de données (220) et l'horloge de base (210) dans l'unité d'évaluation (125) numérique, **caractérisé en ce que** dans l'étape (720) de la formation d'un deuxième mot de données (420) représentant le signal (132) ce deuxième mot de données (420) est formé en utilisant un deuxième désérialiseur (410) d'une deuxième cellule SERDES (400), lequel présente une pluralité de bits, la deuxième cellule SERDES (400) étant soumise à une deuxième horloge de balayage, décalée d'un angle de phase prédéfini par rapport à l'horloge de balayage (205), pour le balayage du signal (132), laquelle est supérieure à l'horloge de base (450). la deuxième cellule SERDES (400) étant soumise à une deuxième horloge de base (450), décalée d'un angle de phase prédéfini par rapport à l'horloge de base (210), et dans l'étape (730) de la détermination l'instant est en outre déterminé en utilisant le deuxième mot de données (420) et dans l'étape (730) de la détermination les valeurs du mot de données (220) et du deuxième mot de données (420) sont assemblées alternativement en valeurs d'un mot complet (500) le moment étant en outre déterminé en utilisant le mot complet (500).

2. Procédé (700) selon la revendication 1, **caractérisé en ce que,** dans l'étape (720) de la formation, une synchronisation de l'horloge de balayage (205) avec l'horloge de base (210) est effectuée, avant que la cellule SERDS (300) soit soumise à l'horloge de balayage (205), l'horloge de balayage (205) et l'horloge de base (210) étant dérivées d'un signal fourni par un générateur d'horloge.

3. Procédé (700) selon l'une quelconque des revendications précédentes, **caractérisé en ce que,** dans l'étape (720) de la formation, un autre mot de données (605) représentant le signal (132) est en outre formé en utilisant un désérialiseur d'une autre cellule SERDES (600), l'autre mot de données (605) présentant une pluralité de bits et l'autre cellule SERES (600) étant en outre soumise à une horloge de balayage (205) pour le balayage du signal (132), laquelle est supérieure à l'horloge de base (210) et la cellule SERDES (300) et l'autre cellule SERDES (600) étant respectivement sensibles à des signes de pentes de fronts différents dans le signal (132), et, dans l'étape de détermination (730), l'instant du front (200) dans le signal (132) est déterminé en utilisant l'autre mot de données (605) et l'horloge de base (210) dans l'unité d'évaluation (125), pour mesurer l'instant du front (200) dans le signal (132).

4. Procédé (700) selon la revendication 3, **caractérisé en ce que,** dans l'étape (720) de la formation, l'autre cellule SERDES (600) est conçue pour sortir un autre mot de données (605), lequel présente un nombre de bits différent de celui du mot de données (220).

5. Procédé (700) selon l'une quelconque des revendications 3 ou 4, **caractérisé en ce que,** dans l'étape (720) de la formation, un mot de données (620) supplémentaire représentant le signal (132) est formé en utilisant un désérialiseur d'une cellule SERDES (610) supplémentaire, lequel présente une pluralité de bits, la cellule SERDES (610) supplémentaire étant soumise à une horloge de balayage (205) supplémentaire décalée d'un angle de phase prédéfini par rapport à l'horloge de balayage pour le balayage du signal (132) et, dans l'étape (730) de la détermination, l'instant est détermine en outre en utilisant le mot de données (620) supplémentaire.

6. Procédé (700) selon l'une quelconque des revendications précédentes, **caractérisé en ce que** le signal dans l'étape (710) de la lecture est retardé avant d'être amené à au moins une des cellules SERDES (300, 400, 600 610).

7. Procédé (750) pour la détermination d'une durée de course et/ou d'une largeur d'impulsion d'un signal de test (130, 130'), un moment et/ou des moments d'un front ascendant et/ou descendant d'un signal de test à émettre (130) et/ou un moment et/ou des moments d'un front ascendant et/ou descendant d'un signal de test reçu (130') est déterminé en utilisant les étapes (710, 720, 730) d'un procédé (700) selon l'une quelconque des revendications 1 à 6, en outre, dans une étape (760) de la détermination, la durée de course étant déterminée en utilisant l'instant du front ascendant et/ou descendant.

8. Procédé (800) selon la revendication 7, la durée de course d'une impulsion laser (130, 130') d'un appareil de surveillance du trafic (100) étant déterminée, en tant que signal de test (130, 130').

9. Unité d'évaluation (125) pour la mesure d'un moment d'un front (200) dans un signal (130), l'unité d'évaluation (125) présentant des dispositifs (135, 140, 150, 300, 320, 330), lesquels sont conçus pour exécuter et/ou commander les étapes (710, 720, 730) d'un procédé (700) selon l'une quelconque des revendications 1 à 6.

10. Unité d'évaluation (125) selon a revendication 9, **caractérisée en ce que** l'unité d'évaluation est conçue comme un circuit intégré numérique.

11. Unité d'évaluation (125) selon l'une quelconque des revendications 9 ou 10, **caractérisée en ce qu'**au moins une borne d'entrée d'horloge est prévue, pour amener l'horloge de base (210) et/ou l'horloge d'échantillonnage (205) de l'unité d'évaluation (125) depuis l'extérieur de l'unité d'évaluation (125).
